# EUROPEAN PATENT SPECIFICATION

(11) **EP 2 752 261 B1**
(45) Date of publication and mention of the grant of the patent: **01.07.2015**
(21) Application number: 13405118.4
(22) Date of filing: 10.10.2013
(51) Int. Cl.: B22F 3/115, B22F 7/06, B22D 23/00, C23C 14/00, C23C 16/01, G04B 37/00, C23C 4/18, B22F 5/00, B22C 7/00, B22C 9/00

(54) **Process for producing watch parts**
Verfahren zur Herstellung von Uhrenteilen
Procédé de production de pièces de montre

(30) Priority: 16.10.2012 CH 20202012
(43) Date of publication of application: 09.07.2014
(60) Divisional application: 15168249.9
(73) Proprietor: Cartier Création Studio S.A., 1201 Genève (CH)
(72) Inventor: Sigrist, Martin, 3005 Bern (CH); Mock, Elmar, 2013 Colombier (CH)
(74) Representative: Frei Patent Attorneys

(56) References cited:
- EP-A2- 0 468 467
- US-A- 2 944 338
- US-A- 3 826 301
- DATABASE WPI Week 198245 Thomson Scientific, London, GB; AN 1982-96728E XP002691078, & JP 57 048633 B (SUWA SEIKOSHA KK) 16 October 1982 (1982-10-16)

## Description

This invention relates to a process for producing parts and in particular to a process for producing watch parts and a mold for producing watch parts and a process for manufacturing a mold according to the preamble of the corresponding independent claims.

EP 0 468 467 discloses a process for producing a precision iron or iron alloy part of a sintered body formed by powder molding, said process comprising the steps of forming a homogeneous mixture consisting essentially of an iron or iron alloy powder, and an organic binder, forming the mixture into a molded body having a prescribed form, removing the organic binder from the molded body in an inert atmosphere, reducing said iron or iron alloy powder contained in the molded body to remove oxygen therefrom and form a reduced molded body and sintering the reduced molded body. In the described process the molding is done by injection molding and only iron parts are manufactured.

EP 1 172 453 discloses a method for making a finally shaped forming tool with a structured forming surfaces having a uniform surface structure, said method comprising the following steps: a) making a glass or plastic mold having a molding surface for forming the structured forming surface of the forming tool; b) coating the molding surface of the glass or plastic mold with at least one material so as to form a cladding body in the glass or plastic mold; c) releasing the cladding body with the structured forming surface from the glass or plastic mold; and d) bonding the cladding body to a base body to form the finally shaped forming tool with the structured forming surface. The coating of the mold is done e.g. by thermal spraying. Materials used for the cladding body are e.g. high melting metallic and ceramic materials whereas alloys of nickel/chromium, cobalt-based alloys and carbides are included in these materials.

Several methods are known to produce polymeric films, as for example in US 2008/10176034, where multiple polymeric layers are produced in a film that thereby replicates a mold surface with microstructures. Each layer is made of epoxy powder sprayed onto the mold and melted and cured by an infra red or UV source.

US 5 301 415 discloses a method for forming an object by applying segments of complementary material and deposition material so as to form layers of material. The layers of material form a block containing the object made of deposition material, which is surrounded by complementary material which serves as a support structure during forming. Then, the complementary material is removed. The complementary material is removed by heating the block whereby the complementary material melts and the deposition material does not melt under the heating conditions. The deposition material and complementary material are preferably applied by thermal spray deposition but may be applied by weld deposition, liquid slurry, gravity drop or any manual means such as a hand sifter.

From the prior art several methods and processes for the build-up of a mold consisting of a particular material are known. Furthermore, processes and methods are known for coating the surface of a part. These coating processes are applied at certain conditions of temperature, pressure, and so on. The process conditions depend e.g. on the used coating material.

The post processing and mechanical finishing of parts which are small and have to comprise a precise structure can be difficult. The difficulties increase in case the part, respectively the surface of the part, has to fulfil high requirements regarding hardness, abrasion and wear resistance, and tribologic properties like in the watch technology. Therefore, there is a need for a process to manufacture watch parts made of a variety of materials, and for a corresponding mold and a process for manufacturing the same.

The object of the invention is to provide a process for producing watch parts and a mold for producing such watch parts and a process for manufacturing a mold which allows manufacturing watch parts made of one or more of a variety of materials.

These objects are achieved by a process for producing watch parts and a mold for producing watch parts and a process for manufacturing a mold according to the corresponding independent claims.

The process for producing a watch part comprises in a first step a provision of a mold with a precise mold shape at an inner mold surface, wherein the precise mold shape corresponds to the negative contours of the watch part to be produced and the mold being made of a mold material. In a second step the mold is filled by a spraying method, wherein the used material corresponds to a watch part material. Furthermore the mold is separated from the watch part in a third step.

As a result, small precisely structured parts are manufactured, which contours are defined by the precise mold shape of the inner mold surface. The precision of the process is related to the fact that the precise mold shape is exactly reproduced by the material filled into the mold. Therefore, a moderately strong adhesion between the mold material and the material of the watch part is desired. Accordingly the outside of the watch part is in close contact to the inner mold surface. The precise mold shape is to be preserved during the filling of the mold by the spraying method. Thus, one characteristic of the mold material is on the one hand a thermal resistance against conditions during the spraying of the part material. On the other hand the mold material has to be separable form the watch part without damaging the precise structure of the watch part.

In an embodiment, at least one of a spraying method and the part material is modified within a spraying step such that the watch part comprises at least a first portion and a second portion having different material properties. This allows for an abrupt or a gradual change of the material properties of the watch part. In a related embodiment, the first portion and the second portion have the same material properties.

In an embodiment, the first portion is a first spraying layer which is coated at least onto the inner mold surface defining the precise shape of the watch part and the second portion is a second spraying layer which is filled into the mold. Thereby, the entire inner mold surface is coated by the first spraying layer. The filling of the mold takes place until a filling level, and the filling level corresponds to at least the dimension of the watch part. This allows to build up a watch part with defined properties of the surface of the watch part, wherein these properties are determined by the first spraying layer and fulfil requirements imposed by the application of the produced part. The spraying method and/or part material can be further modified in the course of spraying the first and/or second spraying layer as well. This leads to corresponding sub-layers with different material properties.

In an alternative embodiment, the first portion is a first spraying layer which is coated onto a portion of the inner mold surface and the second portion is a second spraying layer which is filled into the mold. Thereby, a portion of the second spraying layer is in contact with a portion of the inner mold surface. This allows to determine the material properties of the surface of the part to be different at different locations on the surface of the part. This is advantageous if for example one portion of the part should be wear resistant and a second portion of the part should exhibit certain friction characteristics, e.g. be slidable, according to the requirements imposed by the application of the produced part.

In an embodiment, an additional reworking step is performed on the watch part before the mold is separated from the watch part. This implies that an adhesion force and/or a form fit between the part and the mold is strong enough to sustain the stress present in the course of the reworking. The reworking step accomplishes for example a grinding or a milling. The grinded part material originates from a filling or coating of the mold above a filling level. This overfilling allows to make sure that a desired minimum dimension of the watch part is obtained. Furthermore, small irregularities at the surface can be eliminated. The reworking especially of small and fragile part is simplified by holding the part in the supporting mold.

The mold has to sustain a high thermal loading in the course of the spraying of the part material into the mold. Under these conditions especially the precise mold shape of the inner mold surface should not change its shape significantly. Therefore, requirements to be satisfied by the mold material are e.g. a good formability (in a second state). Furthermore, e.g. a high mechanical stability and a high heat resistance of the mold material (in a first state) are beneficial to preserve a small and precise structure, which corresponds to the exact negative contours of the part to be produced. All these specifications limit the selection of suitable mold material. In the following a possible variety of materials for the mold is presented.

In an embodiment, the mold material comprises or consists of a polymeric material, in particular a polyoxymethylene (POM) or a polyimide (trade name: Kapton). Therefore, a per se known injection molding (IM) is applicable for the provision of the mold, wherein a master mold comprises a master shape, which corresponds to a precise part shape to be built up in the process for producing a watch part.

In an alternative embodiment, the mold material comprises or consists of a metallic material, in particular copper. Due to the material properties of copper like a high thermal strength and stability in combination with its good thermal conductivity the usage of copper as mold material is advantageous.

In an alternative embodiment, the mold material comprises or consists of a material exhibiting a transition from a solid state at a first pressure (mold material in a first state) to a flowable state at a second pressure (mold material in a second state), with the first pressure being lower than the second pressure. This allows the mold material at the second pressure or a higher pressure to adopt a second state and to flow around a master shape present in a die. Due to a release of the pressure to the first pressure the mold material resolidifies by adopting a first state. The negative contours of the master shape are maintained at the inner mold surface after the master mold is removed.

In an alternative embodiment, the mold material comprises or consists of a salt being flowable at the second pressure and solid at the first pressure, the mold material in particular being an alkali metal halide, in particular potassium bromide or potassium iodide or caesium iodide or a mixture of such inorganic salts. Due to the availability especially of inorganic salts, the production of the mold is cost-effective.

In an embodiment, the spraying step is accomplished by a thermal spraying method, the method in particular being a plasma spraying method or a chemical vapor deposition (CVD) method or a plasma enhanced chemical vapor deposition (PECVD) method. This allows to produce a solid part material with a high-purity and a high-performance. The CVD method is able to produce thin layers by at least one of a chemical reaction and a decomposition of a volatile precursor on the mold. Different CVD methods are distinguishable by the chemical reaction and the process conditions used. Furthermore, more uniform layers can be produced by changing the process conditions towards lower pressure (LPCVD, "low pressure chemical vapor deposition") or lower temperature (PECVD).

In an embodiment, the spraying step is accomplished by Physical vapor deposition (PVD), for example, by one or more of Cathodic Arc Deposition, Electron beam physical vapor deposition, Evaporative deposition, Pulsed laser deposition, and Sputter deposition.

The applied spraying methods can be used to produce the first portion and the second portion of the watch part. Therein, a spraying device with a certain set of adjustable parameters is used. After the first portion is sprayed on the inner mold surface, a defined set of parameters is changed and the second portion is sprayed. The changed set of parameters can for example include the temperature or the character of the sprayed material (gaseous, liquid, solid state). This change of parameters can be executed in a continuous manner or abruptly. Either way, the change of parameters gives rise to a change of material properties.

In an embodiment, the first spraying layer is applied by PECVD as a coating onto the entire inner mold surface comprising the precise mold shape, or onto just a portion of this inner mold surface, at a temperature of 200°C to 800°C. By changing the pressure in a range between 10⁻³ mbar and 10 mbar the properties of the coating can be varied. The thickness of the coating can be for example less than 50 micrometers.

In the present text the material the watch part is made of is called part material. The term part material, in the absence of other information, refers to the sprayed material as well as the deposited material, including the first spraying layer and second spraying layer, as well as the material of a so-called 'green part', or a sintered material or the material not yet providing the finally desired properties of the watch part 2.

In an embodiment, at least one portion of the part material comprises or consists of a ceramic-like material, or a pure carbon material, or a metal-oxide, or a metal, or a polymer, or a fluorinated polymer or a hard metal material, in particular a carbide or a nitride, or other materials applicable in a spraying process. This broad variation of part material results in a broad variation of available material properties. In the case of a watch part it is advantageous to have an outer layer (corresponding e.g. to the first spraying layer) which is stable, wear and abrasive resistant. Such properties are for example exhibited by hard materials. Due to these properties, these materials are difficult to process especially if a precise shape has to be worked out. Therefore, it is advantageous to use the first spraying layer in order to provide on the one hand the desired material properties of the surface layer of the watch part. On the other hand the wanted shape can be replicated from the precise mold shape of the inner mold surface.

In an embodiment, the step of separating the mold from the watch part is based on a chemical method and in particular comprises dissolving of the mold material by a solvent, and/or a chemical reaction decomposing the mold material, and/or a melting or burning of the mold material and/or an electrochemical process, in particular a galvanic process. This allows for a very gentle removal of the mold especially the precise mold shape comprises an undercut structure element. Furthermore, this requires that the watch part is resistant against the conditions of a chemical separation.

In an embodiment, the separation of the mold from the watch part is based on a mechanical method and in particular comprises a knocking-off or a breaking of the mold. This allows for a relatively fast removal of the mold especially if the watch part is hard and not fragile.

In an embodiment, the mold comprises an undercut structure. This allows to produce watch parts with a big variety of complex shaped structures.

In an embodiment, the mold including the precise mold shape is completely built up before the spraying step. This allows to apply a homogenous and continuous first spraying layer onto the inner mold surface.

The mold for producing a watch part comprises an inner mold surface with a precise structure. This structure corresponds to a precise mold shape and is coatable by a spraying process. The mold is separable from a coating sprayed onto the inner mold surface. This allows to produce a watch part with a precise structure, as the precise mold shape of the precise mold shape corresponds to the desired watch part structure.

In an embodiment, at least the inner mold surface comprises or consists of a polymeric material, in particular polyoxymethylene (POM) or polyimide, or a metallic material, in particular copper. The inner mold surface can also comprise or consists of a material exhibiting a transition from a solid state at a first pressure (mold material in a first state) to a flowable state at a second pressure (mold material in a second state), with the first pressure being lower than the second pressure and with a melting point being above the conditions present during the spraying process, in particular an inorganic salt. The inorganic salt can be in particular an alkali metal halide, in particular potassium bromide or potassium iodide or caesium iodide or a mixture of such salts. This allows that the mold is stable during the spraying process.

In an embodiment, the inner mold surface is resistant to the conditions present during the spraying process, the process in particular being a plasma spraying method or a chemical vapor deposition method or a plasma enhanced chemical vapor deposition method. This allows to use a large variety of material sprayable by the spraying process.

In an embodiment, the material used for spraying of the inner mold surface comprises or consists of a ceramic-like material, or a metal-oxide, or a pure carbon material, or a pure metal, or a hard metal material, in particular carbide, or nitride, or a fluorinated polymer. This allows to build up the watch part, choosing from and/or combining a variety of material properties.

In an embodiment, the watch part is made up of a single part material with uniform material properties.

In general, the conditions during the spraying of the part material are matched with the properties desired for the application of the watch part. Furthermore, the mold is able to sustain the spraying conditions whereas the mold is removable from the watch part without damaging the watch part.

The subject matter of the invention will be explained in more detail in the following text with reference to preferred exemplary embodiments which are illustrated in the attached drawings, which schematically show:
- Figure 1: a master mold, with a mold material being formed in a die and the mold material maintaining the master shape;
- Figure 2: a (per se) known spraying device for coating the mold;
- Figure 3: a series of stages in the process for producing a precisely structured watch part.

In principle, identical parts are provided with the same reference symbols in the Figures.

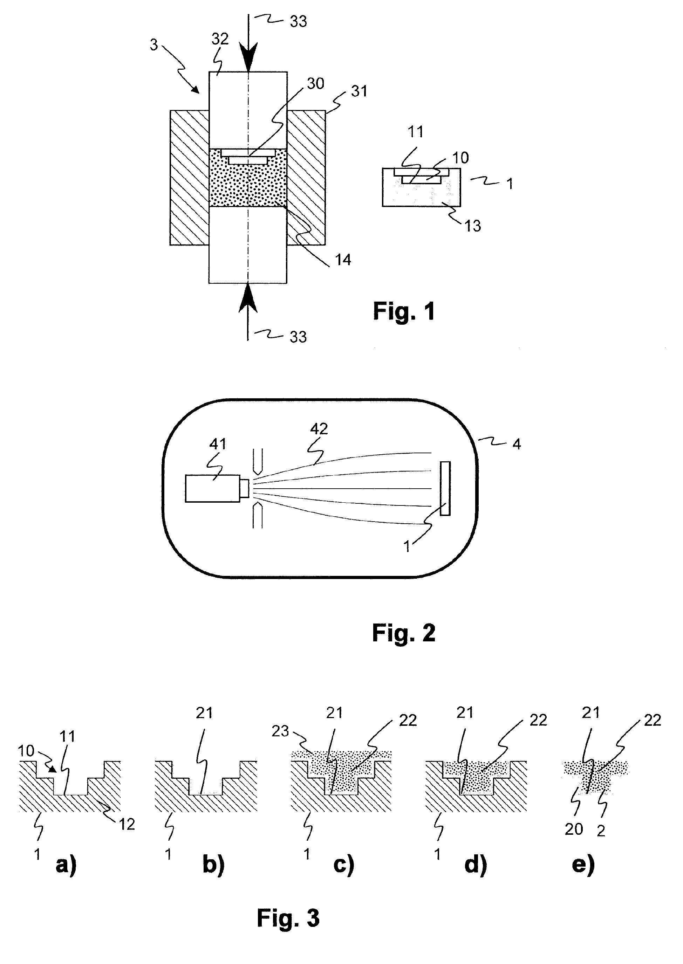

Figure 1 schematically shows a master mold 3 comprising at least one die 31 and/or one press plunger 32. At least one of the die 31 and the press plunger 32 comprises a master shape 30. The master shape 30 defines a precise structure of a watch part 2 to be manufactured, in particular at least a part of the shape of the watch part 2.

The master mold 3 is filled with a mold material 12, wherein the mold material 12 can be a metallic material, in particular cooper, or a polymeric material, in particular polyoxymethylene (POM) or polyimide (Kapton), or a material which is solid at a first pressure and becomes flowable at a second pressure, wherein the first pressure is lower than the second pressure. This material, flowable at the second pressure could be in particular an inorganic salt, in particular an alkali metal halide, in particular potassium bromide or potassium iodide or caesium iodide or a mixture of such salts.

The mold material 12 is pressed into the master mold 3 by a pressing force 33 (arrows) and flows around the master shape 30 of the master mold 3. The flowable mold material 12 therefore adopts the negative contours of the master mold 3 and a future watch part 2. In this flowable state the mold material is in a second state 14.

While or after the release of the pressing force 33 the mold material 12 changes its state to a first state 13. The mold material in a first state 13 is a solid state. In the course of and after this re-solidification from the mold material in a second state 14 to the mold material in a first state 13, the mold material 12 preserves the negative contours of the master mold 3.

In a final step the mold 1 is removed from the master mold 3, wherein the master shape 30 corresponding to a precise part shape 20 is replicated as a precise mold shape 10. This step of removing can utilise the application of mechanical pressure, optionally in combination with a thermal treatment effecting a dilatation of the mold 1 and/or the master mold 3. The precise mold shape 10 is embodied by an inner mold surface 11. At least a surface portion of the inner mold surface 11 is defined by the mold material 12 and is resistant against the conditions present during a subsequent building up of the watch part 2.

In an embodiment, the mold material 12 is a material which is solid at a first pressure and becomes flowable at a second pressure, wherein the first pressure is lower than the second pressure. When the pressing force 33 pressing the mold material 12 into the master mold 3 is high enough to reach at least the second pressure, the liquefied mold material 12 flows around the master shape 30. Afterwards the pressing force 33 is lowered, the mold material 12 becomes solid again and maintains the negative contours of the master shape 30.

In an alternative embodiment, the mold material 12 is a metallic or polymeric material. The mold 1 can be manufactured using a ceramic injection molding (CIM), a metallic injection molding (MIM) or plastic injection molding (PIM), wherein the flowable mold material 12 (mold material in a second state 14) is pressed into a master mold 3 and a so-called 'green part' is cooled and de-molded. Traditionally, such a 'green part' resulting from a CIM, MIM or PIM process is fragile and obtains its resistance in an additional sintering step. For the application as a mold 1, with the precise mold shape 10 at the inner mold surface 11, it is sufficient if the 'green part' can sustain the conditions present during the build up of the watch part 2. Therefore in many cases the sintering step can be skipped, which entails that the mold can be easily destroyed after the building up of the watch part 2.

In an alternative embodiment, the mold 1 is undercut. An undercut structure of the inner mold surface 11 can be realised by using at least two press plungers 32, comprising a master shape 30. The press plungers 32 are able to come in close contact with each other and the mold material 12 is pressed aside. The undercut structure of the inner mold surface 11 can also be realised by a mold 1 comprising at least two mold parts. These mold parts can be combined after re-solidification to constitute the uniform mold 1. The undercut structure of the inner mold surface 11 can be realised in various known ways, e.g. by using a dividable master mold 3 and/or additional movable mold parts which can be removed after re-solidification of the mold material 12 without destroying the precise mold shape 10.

**Figure 2** schematically shows a spraying device 4, wherein the device comprises a spray gun 41. The material sprayed by the spray gun 41, also called sprayed material 42, corresponds to the material the watch part 2 is made of (part material). The sprayed material 42 is sprayed into the mold 1 with the precise mold shape 10.

The spraying device 4 is in particular used for a thermal spraying process, wherein the thermal spraying process can be in particular a plasma spraying method or a chemical vapor deposition (CVD) method or a plasma enhanced chemical vapor deposition (PECVD) method. The plasma spraying method is performed at low pressure, which includes vacuum plasma spraying (VPS) or low pressure plasma spraying (LPPS). The application of CVD processes is advantageous because the layer coated into a surface is very homogenous and a big variation of materials can be deposited as sprayed material 42.

The watch part 2 may have to exhibit a certain combination of properties like a high mechanical strength (hardness), a high abrasion resistance, a high wear-resistance, a small electrical conductivity and as well a high thermal conductivity. Some of these properties, like the mechanical strength, can create huge problems when manufacturing the part in a conventional manner, especially for small and precise structures. These problems can be overcome by the method presented herein, using a sprayed material 42 which comprises the desired properties. Such sprayed material 42 can be a metal oxide, in particular a ceramic-like material, or a pure metal, or a pure carbon material, or a hard metal material, in particular a carbide or a nitride, or a fluorinated polymer, in particular Teflon (brand name by DuPont Co).

In order to build up a watch part 2, the mold 1 comprising the precisely shaped inner mold surface 11 has to sustain the conditions during the spraying process. The temperature during the spraying reaches, for example, up to 200°C or to 500°C or more. This implies a high thermal resistance of the mold 1 and especially of the inner mold surface 11, where the sprayed material 42 has to replicate the precise mold shape 10.

It can be advantageous if that the sprayed material 42 exhibits a strong adherence to the mold material 12 in order to allow for an exact replication of the precise mold shape 10.

The properties desired for a watch part 2 as listed above are mainly related to the properties of the surface of the watch part 2, therefore it is possible to create the watch part 2 as comprising at least two portions. For example, a first portion corresponds to a surface layer or coating of the watch part 2 and a second portion corresponds to an inner filling of the watch part 2. Hence, the watch part 2 is build up in a reverse order, wherein first the surface layer is sprayed into the precise mold shape 10 and secondly the inner filling is deposited onto the surface layer, e.g. filling up the remainder of the mold.

A variation of the properties of the first coating layer 21 and the second coating layer 22 can be controlled or manipulated by varying the type, consistency, flow rate, deposition rate etc. of the sprayed material 42, and/or the thickness of the deposited layer. One possibility to control the thickness and the quality of the deposited layer is usage of the very same spraying device 4 according to different modi operandi. For instance the spraying device 4 can be operated with, that is, fed with, a gaseous material in order to form a thin layer, but later on a solid material (e.g. as powder) can be used, that is, fed to the same spraying device 4, to form a thick layer for filling the precise mold shape 10. The material supplied in the gaseous and solid state can be the same material, or can be different materials. Also the deposition rate can be regulated and affect the properties and quality of the deposited layer by only using a single spraying device 4.

In an alterative embodiment, the mold 1 can be undercut. In such a case it is advantageous that the spraying device 4 and the mold 1 are movable relative to each other, e.g. in a tumbling motion. The tumbling of at least on of the spraying device 4 and mold 1 ensures that the undercut regions of the mold can be coated with the sprayed material 42 and the precise mold shape 10 can be reproduced.

**Figure 3** shows a series of steps in the manufacturing process of a watch part 2. In the first place **(****figure 3a****)** a mold is provided, comprising an inner mold surface 11 with a precise mold shape 10. The precise mold shape 10 corresponds to negative contours of the watch part 2.

In a next step **(****figure 3b****)** a first spraying layer 21 corresponding to a coating is deposited onto the inner mold surface 11. The mold material 12 has to be resistant against the conditions of the spraying because the precise mold shape 10 has to be preserved. The first spraying step comprises a spraying process, in particular a thermal spraying process, in particular a plasma spraying process or a chemical vapor deposition (CVD) process or a plasma enhanced chemical vapor deposition (PECVD) process. Also plasma spraying methods performed at low pressure are applicable in order to build up the first spraying layer 21. The first spraying layer 21 or coating corresponds to the surface of the future watch part 2 and therefore has to exhibit a high quality and high performance regarding hardness and resistance to wearing and abrasion.

In a further step **(****figure 3c****)** a second spraying layer 22 or, in the present case, a filling is deposited onto the first spraying layer 21. There can be differentrequirements on the second spraying layer 22 as compared to the first spraying layer 21. This allows to incorporate complementary material properties in the watch part 2, e.g. with the filling being more elastic, and the coating being harder. Also, depending on requirements, cheaper material can be used for the filling that for the coating. The present example shows two spraying layers, but of course only a single spraying layer or more than two spraying layers with different properties can be applied.

A change of the properties of the spraying layers can be achieved by adapting the coating conditions, such as temperature and/or deposition rate and/or deposition material and/or changing the sprayed material 42 fed to the spraying device 4 from gaseous material to solid material (powder). The composition of subsequent spraying layers can be changed gradually or abruptly. The second spraying layer 22 can be created by filling the mold 1 until at least a filling level is reached.

In a further step **(****figure 3d****)** an excess of material, which might be present at the outer surface of the mold or exceeds the filling level, is milled or ground off. The excess of material may comprise part of the second spraying layer 22 but may also comprise part of the first spraying layer 21. The milling or grinding to remove excess material can be performed in a stage when the watch part 2 is still incorporated into the mold 1 and thereby is mechanically held and stabilized by the mold 1.

In a further step (not shown) an additional layer is sprayed onto the milled or grinded surface. The sprayed material can be the material of the first spraying layer 21 or the second spraying layer 22 or a different material.

In a further step **(****figure 3e****)** the mold 1 and the watch part 2 are separated from each other. The separation step comprises either a chemical method or a mechanical method for the removal of the mold 1. The chemical method in particular comprises dissolving of the mold material 12 by a solvent, and/or a chemical reaction decomposing the mold material 12, and/or a melting or burning of the mold material 12 and/or an electrochemical process, in particular a galvanic process. The mechanical method in particular comprises a knocking-off or a breaking of the mold 1. The watch part 2 or at least the outer surface of the watch part 2 should be resistant to the conditions present in the course of the separation step.

## Claims

1. **A process for producing a watch part** (2), wherein the process comprises the steps of:
- providing a mold (1) with a precise mold shape (10) at an inner mold surface (11), the precise mold shape (10) corresponding to the negative contours of the watch part (2) to be produced and the mold (1) being made of a mold material (12);
- spraying a part material into the mold (1);
- separating the mold (1) from the watch part (2).

2. The process of claim 1 wherein at least one of a spraying method and the part material is modified within a spraying step such that the watch part (2) comprises at least a first portion and a second portion having different or the same material properties.

3. The process of claim 2, wherein the first portion is a first spraying layer (21) which is coated at least onto the inner mold surface (11) defining the precise shape of the watch part (2) and the second portion is a second spraying layer (22) which is filled into the mold, being separated from the mold by the first spraying layer (21).

4. The process of claim 2, wherein the first portion is a first spraying layer (21) which is coated onto a portion of the inner mold surface inner (11) and the second portion is a second spraying layer (22) which is filled into the mold, wherein the second spraying layer (22) is in contact with a portion of the inner mold surface (11).

5. The process of claim 1, wherein the watch part (2) is made in one portion from a single material.

6. The process of any of the preceding claims, wherein an additional reworking step is performed on the watch part (2) before the mold (1) is separated from the watch part (2).

7. The process of one of the claims 1-6, wherein the mold material (12) comprises or consists of a polymeric material, in particular a polyoxymethylene or a polyimide.

8. The process of one of the claims 1-7, wherein the mold material (12) comprises or consists of a metallic material, in particular copper.

9. The process of one of the claims 1-8, wherein the mold material (12) comprises or consists of a material exhibiting a transition from a solid state at a first pressure, the mold material being in a first state (13), to a flowable state at a second pressure, the mold material being in a second state (14), with the first pressure being lower than the second pressure, and in particular with a melting point being above the conditions present during the spraying step.

10. The process according to claim 9, wherein the mold material (12) comprises or consists of a salt being flowable at the second pressure, in particular an alkali metal halide, in particular potassium bromide or potassium iodide or caesium iodide or a mixture of such salts.

11. The process of any of the preceding claims, wherein the spraying step is accomplished by a thermal spraying method, the method in particular being a plasma spraying method or a chemical vapor deposition method or a plasma enhanced chemical vapor deposition method.

12. The process of any of the preceding claims, wherein at least one portion of the part material comprises or consists of a ceramic-like material, or a metal-oxide, or a pure carbon material, or a pure metal, or a hard metal material, in particular carbide, or nitride, or a fluorinated polymer.

13. The process of any of the preceding claims, wherein the step of separating the mold (1) from the watch part (2) is based on a chemical method and in particular comprises dissolving of the mold material (12) by a solvent, and/or a chemical reaction decomposing the mold material (12), and/or a melting or burning of the mold material (12) and/or an electrochemical process, in particular a galvanic process.

14. The process of one of the claims 1-12, wherein the separation of the mold (1) from the watch part (2) is based on a mechanical method and in particular comprises a knocking-off or a breaking of the mold.

15. The process of claim 13, wherein the mold material (12) is resistant against the conditions, in particular the temperature, present during the spraying step and is separable from the precisely structured part by a chemical method.

16. The process of claim 15, wherein the mold material (12) is separable from the part by dissolving of the mold in a polar solvent and wherein the surface material of the watch part (2) is resistant against this polar solvent.

17. The process of claim 15, wherein the mold material (12) is decomposed according to a chemical reaction involving an acid and the surface material of the precisely structured part is acid resistant.

18. The process of any of the preceding claims, wherein the mold (1) comprises an undercut structure.

19. The process of any of the preceding claims, wherein the mold (1) including the precise mold shape (10) is completely built up before the spraying step starts.

## Patentansprüche

1. Verfahren zur Herstellung eines Uhrenteils (2), wobei das Verfahren die Schritte umfasst:
- Bereitstellen eines Formkörpers (1) mit einer präzisen Formgestalt (10) an einer inneren Formkörper-Oberfläche (11), wobei die präzise Formgestalt (10) den negativen Konturen des herzustellenden Uhrenteils (2) entspricht und wobei der Formkörper (1) aus einem Formkörper-Material (12) hergestellt ist;
- Sprühen eines Teil-Materials in den Formkörper (1);
- Entfernen des Formkörpers (1) von dem Uhrenteil (2).

2. Verfahren nach Anspruch 1, wobei mindestens ein Sprühverfahren und das Teil-Material während des Sprüh-Schrittes derart verändert werden, dass das Uhrenteil (2) mindestens einen ersten Anteil und einen zweiten Anteil mit verschiedenen oder den gleichen Materialeigenschaften umfasst.

3. Verfahren nach Anspruch 2, wobei der erste Anteil eine erste Sprühschicht (21) ist, welche mindestens die innere Formkörper-Oberfläche (11) überzieht, dabei die präzise Formgestalt des Uhrenteils (2) definierend und der zweite Anteil eine zweite Sprühschicht (22) ist, die in den Formkörper gefüllt wird und von dem Formkörper durch die erste Sprühschicht (21) getrennt ist.

4. Verfahren nach Anspruch 2, wobei der erste Anteil eine erste Sprühschicht (21) ist, die einen Teil der inneren Formkörper-Oberfläche (11) überzieht und der zweite Anteil eine zweite Sprühschicht (22) ist, die in den Formkörper gefüllt wird, wobei die zweite Sprühschicht (22) mit einem Teil der inneren Formkörper-Oberfläche (11) in Kontakt ist.

5. Verfahren nach Anspruch 1, wobei der Uhrenteil (2) als ein einzelner Anteil aus einem einzigen Material hergestellt ist.

6. Verfahren nach einem der vorangegangenen Ansprüche, wobei ein zusätzlicher Überarbeitungsschritt an dem Uhrenteil (2) durchgeführt wird, bevor der Formkörper (1) von dem Uhrenteil (2) entfernt wird.

7. Verfahren nach einem der Ansprüche 1-6, wobei das Formkörper-Material (12) ein polymeres Material, insbesondere ein Polyoxymethylen oder ein Polyimid umfasst oder daraus besteht.

8. Verfahren nach einem der Ansprüche 1-7, wobei das Formkörper-Material (12) ein metallisches Material, insbesondere Kupfer umfasst oder daraus besteht.

9. Verfahren nach einem der Ansprüche 1-8, wobei das Formkörper-Material (12) ein Material umfasst oder daraus besteht, welches bei einem ersten Druck einen Übergang von einem festen Zustand, das Formkörper-Material ist in einem ersten Zustand (13), in einen fliessfähigen Zustand bei einem zweiten Druck zeigt, das Formkörper-Material ist in einem zweiten Zustand, wobei der erste Druck geringer als der zweite Druck ist, und wobei insbesondere der Schmelzpunkt über den während des Sprühvorgangs herrschenden Bedingungen liegt.

10. Verfahren gemäss Anspruch 9, wobei das Formkörper-Material (12) ein Salz umfasst oder daraus besteht, welches bei einem zweiten Druck fliessfähig ist und insbesondere ein Alkalimetallhalogenid, insbesondere Kaliumbromid oder Kaliumjodid oder Caesiumjodid oder eine Mischung solcher Salze ist.

11. Verfahren nach einem der vorangegangenen Ansprüche, wobei der Sprüh-Schritt mittels eines thermischen Sprühverfahren durchgeführt wird, wobei das Verfahren insbesondere ein Plasmasprühverfahren oder ein chemisches Gasphasenabscheidungsverfahren oder ein Plasma verstärktes chemisches Gasphasenabscheidungsverfahren ist.

12. Verfahren nach einem der vorangegangenen Ansprüche, wobei mindestens ein Anteil des Teil-Materials keramikähnliches Material oder ein Metalloxid oder ein reines Kohlenstoffmaterial oder ein reines Metall oder ein hartes metallisches Material, insbesondere Carbid oder Nitrid oder ein fluoriertes Polymer umfasst oder daraus besteht.

13. Verfahren nach einem der vorangegangenen Ansprüche, wobei der Schritt des Entfernens des Formkörpers (1) von dem Uhrenteil (2) auf einem chemischen Verfahren basiert und insbesondere ein Auflösen des Formkörper-Materials (12) durch ein Lösungsmittel und/oder eine chemische Reaktion, die das Formkörper-Material (12) zersetzt und/oder ein Schmelzen oder Verbrennen des Formkörper-Materials (12) und/oder ein elektrochemisches Verfahren, insbesondere ein galvanisches Verfahren umfasst.

14. Verfahren nach einem der Ansprüche 1-12, wobei das Entfernen des Formkörpers (1) von dem Uhrenteil (2) auf einem mechanischen Verfahren basiert und insbesondere ein Abklopfen oder Abbrechen des Formkörpers umfasst.

15. Verfahren nach Anspruch 13, wobei das Formkörper-Material (12) resistent gegenüber Bedingungen wie insbesondere der Temperatur ist, die während des Sprüh-Schritts herrscht und von dem präzise strukturierten Teil durch ein chemisches Verfahren entfernbar ist.

16. Verfahren nach Anspruch 15, wobei das Formkörper-Material (12) von dem Teil abtrennbar ist, indem der Formkörper in einem polaren Lösungsmittel aufgelöst wird und wobei das Oberflächenmaterial des Uhrenteils (2) resistent gegenüber dem polaren Lösungsmittel ist.

17. Verfahren nach Anspruch 15, wobei das Formkörper-Material (12) gemäss einer eine Säure einschliessenden chemischen Reaktion zersetzt wird, und das Oberflächenmaterial des präzise strukturierten Teils säureresistent ist.

18. Verfahren nach einem der vorangegangenen Ansprüche, wobei der Formkörper (1) eine Unterschnitt-Struktur umfasst.

19. Verfahren nach einem der vorangegangenen Ansprüche, wobei der Formkörper (1), die präzise Formgestalt (10) einschliessend, vollständig aufgebaut ist, bevor der Sprüh-Schritt durchgeführt wird.

## Revendications

1. Procédé de production d'une pièce de montre (2), le procédé comportant les étapes qui consistent à :
- prévoir un moule (1) présentant une forme précise (10) sur la surface intérieure (11) du moule, la forme précise (10) du moule correspondant aux contours négatifs de la pièce de montre (2) à produire et le moule (1) étant réalisé en un matériau de moule (12) ;
- pulvériser un matériau de pièce dans le moule (1) ;
- séparer le moule (1) de la pièce de montre (2).

2. Procédé selon la revendication 1, dans lequel on modifie la méthode de pulvérisation et/ou le matériau de la pièce au cours de l'étape de pulvérisation, de telle sorte que la pièce de montre (2) comprenne au moins une première partie et une deuxième partie dont les propriétés du matériau sont identiques ou différentes.

3. Procédé selon la revendication 2, dans lequel la première partie est une première couche de pulvérisation (21) appliquée au moins sur la surface intérieure (11) du moule qui définit la forme précise de la pièce de montre (2), la deuxième partie étant une deuxième couche de pulvérisation (22) introduite dans le moule et séparée du moule par la première couche de pulvérisation (21).

4. Procédé selon la revendication 2, dans lequel la première partie est une première couche de pulvérisation (21) appliquée sur une partie de la surface intérieure (11) du moule, la deuxième partie étant une deuxième couche de pulvérisation (22) qui remplit le moule, la deuxième couche de pulvérisation (22) étant en contact avec une partie de la surface intérieure (11) du moule.

5. Procédé selon la revendication 1, dans lequel la pièce de montre (2) est réalisée en une pièce d'un seul matériau.

6. Procédé selon l'une quelconque des revendications précédentes, dans lequel une étape supplémentaire de travail est réalisée sur la pièce de montre (2) avant que le moule (1) soit séparé de la pièce de montre (2).

7. Procédé selon l'une des revendications 1 à 6, dans lequel la matériau (12) du moule comprend ou est constitué d'un matériau polymère, en particulier un polyoxyméthylène ou un polyimide.

8. Procédé selon l'une des revendications 1 à 7, dans lequel le matériau (12) du moule comprend ou est constitué d'un matériau métallique, en particulier le cuivre.

9. Procédé selon l'une des revendications 1 à 8, dans lequel le matériau (12) du moule comprend ou est constitué d'un matériau qui présente une transition entre l'état solide à une première pression à laquelle le matériau du moule est dans un premier état (13) et un état coulable à une deuxième pression à laquelle le matériau du moule est dans un deuxième état (14), la première pression étant inférieure à la deuxième pression, le matériau du moule présentant en particulier un point de fusion situé au-dessus des conditions qui règnent pendant l'étape de pulvérisation.

10. Procédé selon la revendication 9, dans lequel le matériau (12) du moule comprend ou est constitué d'un sel coulable à la deuxième pression, en particulier un halogénure de métal alcalin, en particulier le bromure de potassium, l'iodure de potassium, l'iodure de césium ou un mélange de ces sels.

11. Procédé selon l'une quelconque des revendications précédentes, dans lequel l'étape de pulvérisation est réalisée par une méthode de pulvérisation thermique, le procédé étant en particulier un procédé de pulvérisation au plasma, une méthode de dépôt chimique de vapeur ou une méthode de dépôt chimique de vapeur renforcé par plasma.

12. Procédé selon l'une quelconque des revendications précédentes, dans lequel au moins une partie du matériau de la pièce comprend ou est constituée d'un matériau de type céramique, d'un oxyde métallique, d'un matériau de carbone pur, d'un métal pur, d'un matériau de métal dur, en particulier un carbure ou un nitrure, ou d'un polymère fluoré.

13. Procédé selon l'une quelconque des revendications précédentes, dans lequel l'étape de séparation du moule (1) de la pièce de montre (2) est basée sur une méthode chimique et en particulier comprend la dissolution du matériau (12) du moule par un solvant et/ou une réaction chimique qui décompose le matériau (12) du moule et/ou la fusion ou la combustion du matériau (12) du moule et/ou une opération électrochimique, en particulier une opération galvanique.

14. Procédé selon l'une des revendications 1 à 12, dans lequel la séparation du moule (1) de la pièce de montre (2) est basée sur une méthode mécanique et en particulier comprend une percussion ou la rupture du moule.

15. Procédé selon la revendication 13, dans lequel le matériau (12) du moule résiste aux conditions et en particulier de température qui règnent pendant l'étape de pulvérisation et peut être séparé de la pièce de structure précise par une méthode chimique.

16. Procédé selon la revendication 15, dans lequel le matériau (12) du moule peut être séparé de la pièce en dissolvant le moule dans un solvant polaire et dans lequel le matériau de surface de la pièce de montre (2) résiste à ce solvant polaire.

17. Procédé selon la revendication 15, dans lequel le matériau (12) du moule est décomposé par une réaction chimique qui recourt à un acide, le matériau de surface de la pièce de structure précise résistant aux acides.

18. Procédé selon l'une quelconque des revendications précédentes, dans lequel le moule (1) comprend une structure en contre-dépouille.

19. Procédé selon l'une quelconque des revendications précédentes, lequel le moule (1) comprenant la forme précise (10) de moule est construit complètement avant le début de l'étape de pulvérisation.
